# EUROPEAN PATENT SPECIFICATION

(11) **EP 2 715 997 B1**
(45) Date of publication and mention of the grant of the patent: **27.11.2019**
(21) Application number: 12726996.7
(22) Date of filing: 31.05.2012
(51) Int. Cl.: H04L 25/49, H04L 27/04, H04B 14/02

(54) **DELTA MODULATED LOW POWER EHF COMMUNICATION LINK**
DELTA-MODULIERTE NIEDRIGENERGETISCHE EHF-KOMMUNIKATIONSVERBINDUNG
LIAISON DE COMMUNICATION EHF BASSE PUISSANCE À MODULATION DELTA

(30) Priority: 31.05.2011 US 201161491811 P
(43) Date of publication of application: 09.04.2014
(73) Proprietor: Keyssa, Inc., Mountain View, CA 94041 (US)
(72) Inventor: MCCORMACK, Gary, D., Tigard, OR 97223 (US); KYLES, Ian, A., West Linn, OR 97068 (US)
(74) Representative: Hoefer & Partner Patentanwälte mbB
(86) International application number: PCT/US2012/040214
(87) International publication number: WO 2012/166922

(56) References cited:
- US-A- 3 796 831
- US-A- 4 497 068
- US-A- 4 694 504

## Description

### Field of the Disclosure

This disclosure relates to systems and methods for EHF communications, including modulation of EHF signals.

### Background of the Disclosure

Advances in semiconductor manufacturing and circuit design technologies have enabled the development and production of integrated circuits (ICs) with increasingly higher operational frequencies. In turn, electronic products and systems incorporating such integrated circuits are able to provide much greater functionality than previous generations of products. This additional functionality has generally included the processing of increasingly larger amounts of data at increasingly higher speeds.

Many electronic systems include multiple printed circuit boards (PCBs) upon which these high-speed ICs are mounted, and through which various signals are routed to and from the ICs. In electronic systems with at least two PCBs and the need to communicate information between those PCBs, a variety of connector and backplane architectures have been developed to facilitate information flow between the boards. Connector and backplane architectures introduce a variety of impedance discontinuities into the signal path, resulting in a degradation of signal quality or integrity. Connecting to boards by conventional means, such as signal-carrying mechanical connectors, generally creates discontinuities, requiring expensive electronics to negotiate. Conventional mechanical connectors may also wear out over time, require precise alignment and manufacturing methods, and are susceptible to mechanical jostling.
US 4 694 504 A discloses an optical fiber communications link which by means of pulse-width-modulation (PWM) encoding supports either synchronous or asynchronous data transmission and operation over a wide range of data rates. The link utilizes a PWM encoder which accepts either synchronous (clock plus data) or asynchronous (data only) binary inputs and generates a PWM encoded waveform. This waveform is transmitted via an optical transmitter, optical channel (e.g., fiber optics) and optical receiver to the PWM decoder which reconstructs the binary inputs. The optical receiver contains a receiver circuit for assuring automatic gain control regardless of the duty cycle. In the synchronous mode of operation the unsymmetrical clock output is restored to symmetry by using a clock symmetry restoration technique.
US 4 497 068 A discloses an encoding circuitry which is provided for optic digital data transmission. A transmitter transmits a pair of timed optic pulses of different duration in response to respective leading and trailing edges of a data pulse. A receiver reconstitutes the data pulse by decoding the different duration optic pulse widths. The receiver includes a pulse generator generating a pulse width between that of the pair of transmitted pulses, and compares the generated pulse width against the pulse width then received from the transmitter, for determining positive and negative-going transitions in the reconstituted data stream.
US 3 796 831 A discloses a pulse modulation and detection communications system suitable for use with high-power carrier sources such as light emitting diodes or transferred electron oscillators, the zero axis crossings of an audio frequency signal are used to control the output pulse width of the carrier source. The carrier pulses are detected and frequency divided to provide a square wave exhibiting the same zero axis crossings as the original audio frequency signal. The detected square wave is filtered before being applied to an audio signal output device.

### Summary of the Disclosure

Systems for communicating modulated extremely high frequency signals according to the invention are defined in independent claims 1, and 10, and methods for communicating modulated extremely high frequency signals are defined in independent claims 11 and 12. Preferred embodiments thereof are respectively defined in the respective following dependent claims.

In one example, a system for communicating modulated EHF signals may include a modulation circuit responsive to a bi-level transmit information signal for generating a transmit output signal having an EHF frequency when the transmit information signal is at a first information state and suppressing the transmit output signal when the transmit information signal is at a second information state different than the first information state. A transmit transducer operatively coupled to the modulation circuit may be responsive to the transmit output signal for converting the transmit output signal into an electromagnetic signal.

In another example, a system for communicating modulated EHF signals may include a receive transducer responsive to an electromagnetic signal having the EHF frequency for converting the electromagnetic signal into a receive input signal having a first signal strength for intermittent periods and a second signal strength less than the first signal strength otherwise. A demodulation circuit operatively coupled to the receive transducer may be responsive to the receive input signal for generating a receive information signal having a first information state when the receive input signal has the first signal strength and having a second information state when the receive input signal has the second signal strength.

In an exemplary method for communicating modulated EHF signals, a modulation circuit may generate a transmit output signal having an EHF frequency when a transmit information signal is at a first information state. The transmit output signal may be suppressed when the transmit information signal is at a second information state different than the first information state. A transmit transducer may convert the transmit output signal into an electromagnetic signal.

In another exemplary method for communicating modulated EHF signals, a receive transducer may receive an electromagnetic signal and convert the electromagnetic signal into a receive input signal having a first signal strength for intermittent periods and a second signal strength less than the first signal strength otherwise. A demodulation circuit responsive to the receive input signal may regenerate a receive information signal having a first information state when the receive input signal has the first signal strength and having a second information state when the receive input signal has the second signal strength.

Advantages of such systems and methods will be more readily understood after considering the drawings and the Detailed Description.

### Brief Description of the Drawings

Fig. 1 shows a simplified schematic overhead view of a first example of an integrated circuit (IC) package including a die and antenna.
Fig. 2 shows a schematic side view of an exemplary communication device including an IC package and printed circuit board (PCB).
Fig. 3 shows an isometric view of another exemplary communication device including an IC package with external circuit conductors.
Fig. 4 shows a bottom view of the exemplary communication device of Fig. 3.
Fig. 5 shows a block diagram of an exemplary communication system.
Fig. 6 is a circuit diagram of an illustrative edge detecting circuit.
Fig. 7 shows an illustrative data signal of Figs. 5 and 6 representing binary information.
Fig. 8 shows an illustrative information signal for one example of the edge-detecting circuit of Figs. 5 and 6.
Fig. 9 shows an illustrative information signal of another example of the edge-detecting circuit of Figs. 5 and 6.
Fig. 10 is a circuit diagram of an illustrative modulation circuit and transducer.
Fig. 11 is a circuit diagram of another illustrative modulation circuit and transducer.
Fig. 12 is a circuit diagram of an illustrative demodulation and sampling circuit.
Fig. 13 shows an illustrative information signal converted to a corresponding illustrative data signal in a demodulation and sampling circuit.
Fig. 14 is a circuit diagram of another illustrative demodulation and sampling circuit.
Fig. 15 shows an illustrative method for communicating an EHF signal using modulation.

### Detailed Description of the Disclosure

Wireless communication may be used to provide signal communications between components on a device or may provide communication between devices. Wireless communication provides an interface that is not subject to mechanical and electrical degradation. Examples of systems employing wireless communication between chips are disclosed in U.S. Patent No. 5,621,913 and U.S. Published Patent Application No. 2010/0159829.

In one example, tightly-coupled transmitter/receiver pairs may be deployed with a transmitter disposed at a terminal portion of a first conduction path and a receiver disposed at a terminal portion of a second conduction path. The transmitter and receiver may be disposed in close proximity to each other depending on the strength of the transmitted energy, and the first conduction path and the second conduction path may be discontiguous with respect to each other. In some examples, the transmitter and receiver may be disposed on separate circuit carriers positioned with the antennas of the transmitter/receiver pair in close proximity.

As discussed below, in one example a transmitter and/or receiver may be configured as an IC package, in which one or more antennas may be positioned adjacent to a die and held in place by a dielectric or insulating encapsulation or bond material. An antenna may also be held in place by a lead frame substrate. Examples of EHF antennas embedded in IC packages are shown in the drawings and described below. Note that IC packages may also be referred to as EHF IC packages or simply packages, and are examples of wireless communication units that are also variously referred to as EHF communication units, communication units, communication devices, comm-link chip packages, and/or comm-link packages.

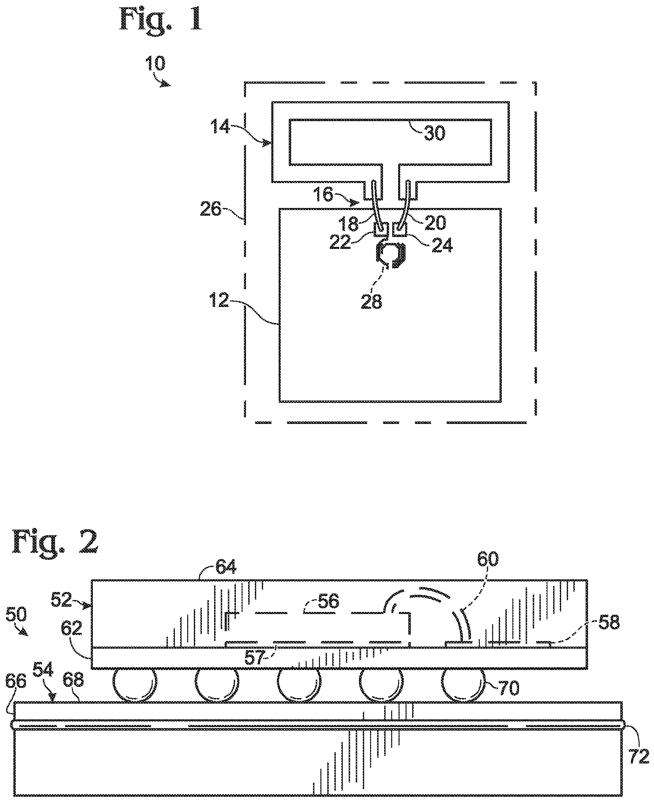

Fig. 1 shows an exemplary IC package, generally indicated at 10. IC package 10 includes a chip or die 12, a transducer 14 providing conversion between electrical and electromagnetic (EM) signals, and conductive connectors 16, such as bond wires 18, 20 electrically connecting the transducer to bond pads 22, 24 connected to a transmitter or receiver circuit included in die 12. IC package 10 further includes an encapsulating material 26 formed around at least a portion of the die and/or the transducer. In this example encapsulating material 26 covers die 12, conductive connectors 16, and transducer 14, and is shown in phantom lines so that details of the die and transducer may be illustrated in solid lines.

Die 12 includes any suitable structure configured as a miniaturized circuit on a suitable die substrate, and is functionally equivalent to a component also referred to as a chip or an integrated circuit (IC). A die substrate may be any suitable semiconductor material; for example, a die substrate may be silicon. Die 12 may have a length and a width dimension, each of which may be about 1.0 mm to about 2.0 mm, and preferably about 1.2 mm to about 1.5 mm. Die 12 may be mounted with further electrical conductors 16, such as a lead frame, not shown in Fig. 1, providing connection to external circuits. A transformer 28, shown in dashed lines, may provide impedance matching between a circuit on die 12 and transducer 14.

Transducer 14 may be in the form of a folded dipole or loop antenna 30, may be configured to operate at radio frequencies such as in the EHF spectrum, and may be configured to transmit and/or receive electromagnetic signals. Antenna 30 is separate from but operatively connected to die 12 by suitable conductors 16, and is located adjacent to die 12.

The dimensions of antenna 30 are suitable for operation in the EHF band of the electromagnetic frequency spectrum. In one example, a loop configuration of antenna 30 includes a 0.1 mm band of material, laid out in a loop 1.4 mm long and 0.53 mm wide, with a gap of 0.1 mm at the mouth of the loop, and with the edge of the loop approximately 0.2 mm from the edge of die 12.

Encapsulating material 26 is used to assist in holding the various components of IC package 10 in fixed relative positions. Encapsulating material 26 may be any suitable material configured to provide electrical insulation and physical protection for the electrical and electronic components of IC package 10. For example, encapsulating material 26, also referred to as insulating material, may be a mold compound, glass, plastic, or ceramic. Encapsulating material 26 may also be formed in any suitable shape. For example, encapsulating material 26 may be in the form of a rectangular block, encapsulating all components of IC package 10 except the unconnected ends of conductors 16 connecting the die to external circuits. External connections may be formed with other circuits or components.

Fig. 2 shows a representational side view of a communication device 50 including an IC package 52 flip-mounted to an exemplary printed circuit board (PCB) 54. In this example, it may be seen that IC package 52 includes a die 56, a ground plane 57, an antenna 58, bond wires, including bond wire 60, connecting the die to the antenna. The die, antenna, and bond wires are mounted on a package substrate 62 and encapsulated in encapsulating material 64. Ground plane 57 may be mounted to a lower surface of die 56, and may be any suitable structure configured to provide an electrical ground for the die. PCB 54 may include a top dielectric layer 66 having a major face or surface 68. IC package 52 is flip-mounted to surface 68 with flip-mounting bumps 70 attached to a metallization pattern (not shown).

PCB 54 may further include a layer 72 spaced from surface 68 made of conductive material forming a ground plane within PCB 54. The PCB ground plane may be any suitable structure configured to provide an electrical ground to circuits and components on PCB 54.

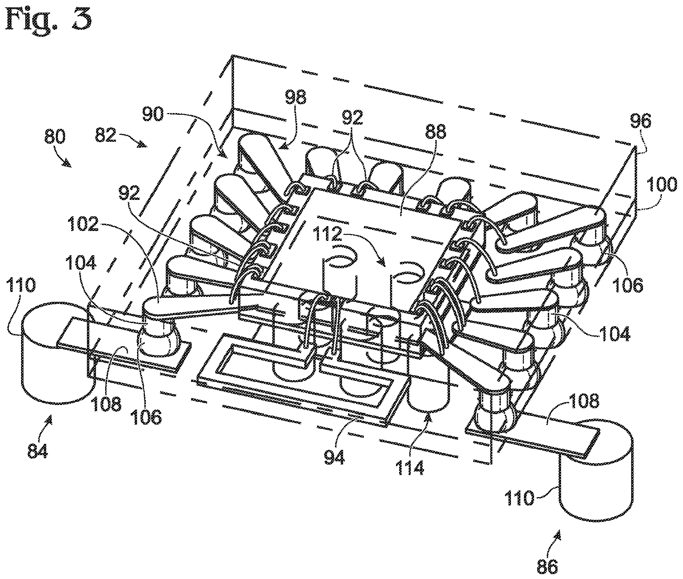

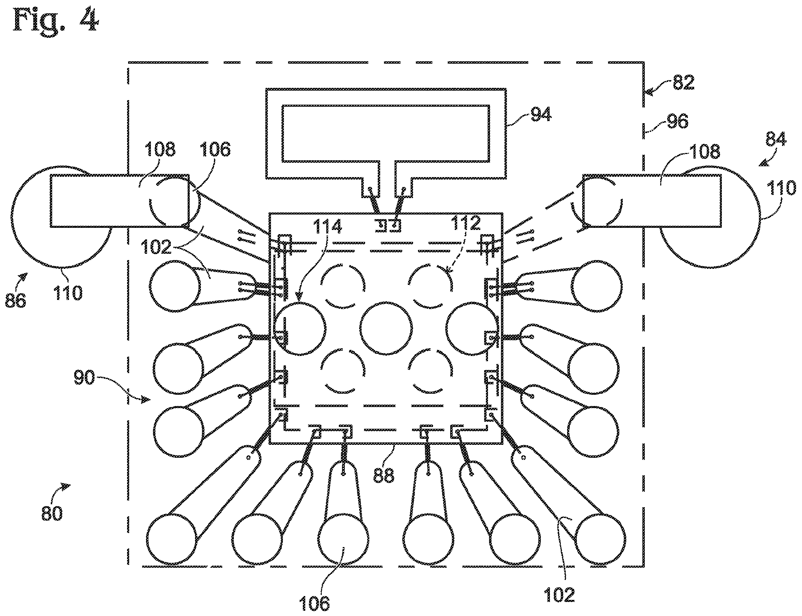

Figs. 3 and 4 illustrate another exemplary communication device 80 including an IC package 82 with external circuit conductors 84 and 86. In this example, IC package 82 may include a die 88, a lead frame 90, conductive connectors 92 in the form of bond wires, an antenna 94, encapsulating material 96, and other components not shown to simplify the illustration. Die 88 may be mounted in electrical communication with lead frame 90, which may be any suitable arrangement of electrical conductors or leads 98 configured to allow one or more other circuits to operatively connect with die 90. Antenna 94 may be constructed as a part of the manufacturing process that produces lead frame 90.

Leads 98 may be embedded or fixed in a lead frame substrate 100, shown in phantom lines, corresponding to package substrate 62. The lead frame substrate may be any suitable insulating material configured to substantially hold leads 98 in a predetermined arrangement. Electrical communication between die 88 and leads 98 of lead frame 90 may be accomplished by any suitable method using conductive connectors 92. As mentioned, conductive connectors 92 may include bond wires that electrically connect terminals on a circuit of die 88 with corresponding lead conductors 98. For example, a conductor or lead 98 may include a plated lead 102 formed on an upper surface of lead frame substrate 100, a via 104 extending through the substrate, a flip-mounting bump 106 mounting IC package 82 to a circuit on a base substrate, such as a PCB, not shown. The circuit on the base substrate may include a external conductors, such as external conductor 84, which for example, may include a strip conductor 108 connecting bump 106 to a further via 110 extending through the base substrate. Other vias 112 may extend through the lead frame substrate 100 and there may be additional vias 114 extending through the base substrate.

In another example, die 88 may be inverted and conductive connectors 92 may include bumps, or die solder balls, as described previously, which may be configured to electrically connect points on a circuit of die 88 directly to corresponding leads 98 in what is commonly known as a "flip chip" arrangement.

A first and a second IC package 10 may be co-located on a single PCB and may provide intra-PCB communication. In other examples, a first IC package 10 may be located on a first PCB and a second IC package 10 may be located on a second PCB and may therefore provide inter-PCB communication.

In order to reduce power consumption and achieve other benefits, a data signal being communicated from one IC package 10 to another may be communicated by modulating a carrier signal to encode the data in the data signal. In some examples, a method of delta modulation may be used, such as by transmitting pulses of EHF radiation indicating that a transition in the binary data signal has occurred. These pulses may then be received by another IC package 10 and demodulated by translating the pulsed EHF signal again into a standard binary data signal for use in an electronic circuit. An IC package such as IC package 10 may include multiple circuits to carry out various functions related to transmission of modulated EHF signals and corresponding reception and demodulation of such signals.

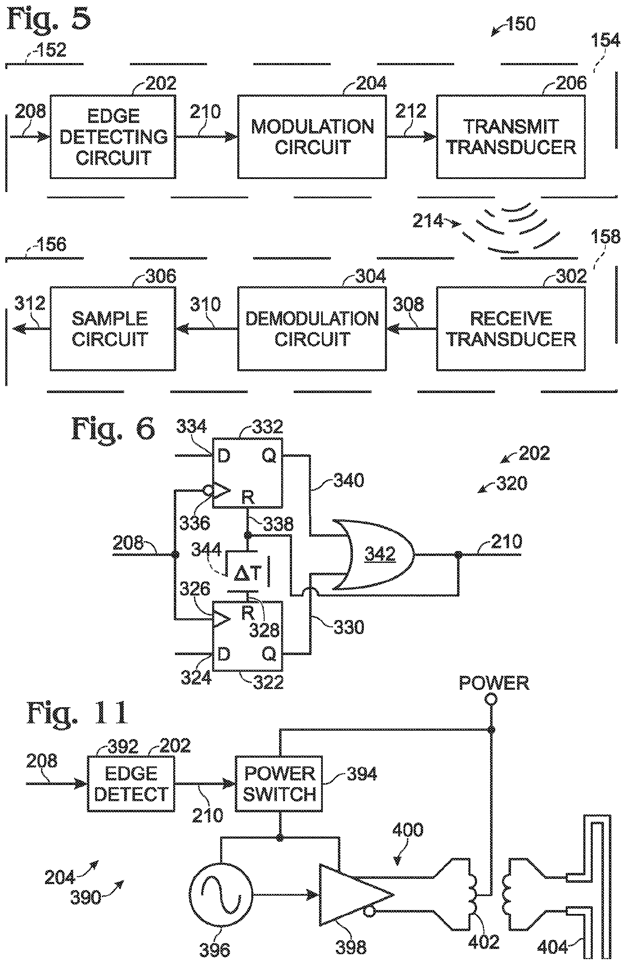

Fig. 5 shows an exemplary communication system generally indicated at 150 including examples of circuits that may be included to facilitate communication using a modulated signal. As depicted in Fig. 5, a transmitter 152, which may be embodied in a transmitting IC package 154, may communicate with a receiver 156, which may be embodied in a receiving IC package 158. Transmitting IC package 154 and receiving IC package 158 may be examples of IC package 10. Transmitter 152 may include circuits such as an edge detecting circuit 202 operatively coupled with a modulation circuit 204 for providing an output signal to a transmit transducer 206. Receiver 154 may include a receive transducer 302 providing a signal to circuits such as a demodulation circuit 304 operatively coupled to a sample circuit 306.

Edge detecting circuit 202 may be any suitable electronic circuit configured to detect edge conditions in a binary data input signal 208 provided by a data signal source (not shown). Data input signal 208 may be any data-carrying binary electronic signal such as a non-return-to-zero (NRZ) data signal commonly utilized in modern electronics. Data input signal 208 may have two binary states, one representative of a data bit '1' and one representative of a data bit '0,' and may encode digital input data. Detecting edge conditions refers to detection of a transition from one binary state to another in data input signal 208, such as when the data input signal swings from one voltage level to another, such as from positive to negative and vice versa. Edge detecting circuit 202 may be configured to generate a bi-level transmit information signal 210 including an edge-indicating pulse generated in response to each transition between binary states in data input signal 208.

The transmit information signal 210 may be provided to modulation circuit 204. Modulation circuit 204 may be any suitable electronic circuit configured to be responsive to bi-level transmit information signal 210, and to generate a transmit output signal 212. Transmit output signal 212 may be produced by modulation circuit 204 as an electronic signal that has an EHF frequency when transmit information signal 210 is at a first information state, and suppressed by modulation circuit 204 when transmit information signal 210 is at a second information state. For example, transmit output signal 212 may be pseudo-intermittent, with a signal generated at an EHF frequency at the time and for the duration of a pulse in signal 210, and being suppressed otherwise, i.e., when no pulse is occurring in signal 210.

Modulation circuit 204 may be operatively coupled to transmit transducer 206, which may be an example of transducer 14, such that transmit output signal 212 may be converted from an electrical signal into an electromagnetic (EM) signal 214. For example, transducer 206 may be an antenna, such as a dipole antenna, sized and configured to operate in the EHF frequency range.

EM signal 214 may further be communicated to a second transducer such as receive transducer 302, which may be an example of transducer 14 on IC package 158. Receive transducer 302 may be an antenna configured to receive EHF signals such as EM signal 214. Transducer 302 may be configured to convert EM signal 214 into an electrical receive input signal 308. Receive input signal 308 may correspond to transmit output signal 212 in that the two electronic signals may be substantially identical due to having merely been translated through an intermediate EM signal. Accordingly, receive input signal 308 may have a first signal strength or amplitude with an EHF frequency at intermittent periods and a second signal strength or amplitude less than the first signal strength otherwise.

Demodulation circuit 304 may be operatively coupled to receive transducer 302. Demodulation circuit 304 may be any suitable circuit configured to respond to receive input signal 308 for generating a receive information signal 310 having two information states, one when the receive input signal 308 has the first signal strength and one when receive input signal 308 has the second signal strength. Receive information signal 310 may correspond to transmit information signal 210 in that it may be a bi-level signal including edge-indicating pulses that indicate each transition between binary states in a data signal being regenerated by receiver 156.

Sample circuit 306 may be coupled to demodulation circuit 304 and may be any suitable circuit configured to respond to receive information signal 310 for generating a data output signal 312 having a two binary states, one representative of a data bit '1' and one representative of a data bit '0.' Sample circuit 306 may generate a transition in the data output signal between the two states each time a pulse occurs in receive information signal 310. Data output signal 312 may correspond to data input signal 208 in that the digital information encoded by signal 312 will correspond to the digital information encoded by signal 208. The data output signal 312 may be provided to a data circuit (not shown) coupled to receiver 156.

Fig. 6 shows a simplified electronic circuit diagram of an exemplary edge detecting circuit 320, which is an example of an edge detecting circuit 202 described above. This example of an edge detecting circuit includes a D-type positive-edge flip-flop 322 having a D input 324 that receives a continuous logic '1' state, a clock input 326 that receives data input signal 208, and a reset input 328 that receives the bi-level transmit information signal 210. Positive-edge flip-flop 322 produces a first flip-flop output signal 330 in response to the states of the signals on D input 324, clock input 326, and reset input 328. Positive-edge flip-flop 322 may be any circuit or component configured to output the D value in response to a rising change in the clock input. In other words, in this example first flip-flop output signal 330 has the value '1' when data input signal 208 changes from low to high.

With continuing reference to Fig. 6, exemplary edge detecting circuit 320 also includes a negative-edge D-type negative-edge flip-flop 332 having a D input 334 that receives a continuous logic '1' state, a clock input 336 that receives a negative or complement of data input signal 208, and a reset input 338 configured to receive the bi-level transmit information signal 210. Negative-edge flip-flop 332 produces a second flip-flop output signal 340 in response to the states of the signals on D input 334, clock input 336, and reset input 338. Negative-edge flip-flop 332 may be any circuit or component configured to output the D value in response to a falling change in the clock input. In other words, second flip-flop output signal 340 will have a value '1' when data input signal 208 changes from high to low.

Still referring to Fig. 6, the output signals of flip-flops 322 and 332 both feed into an OR logic gate 342 that responds to the two signals 330 and 340 for producing transmit information signal 210. OR logic gate 342 may be any suitable circuit or component having two binary inputs and configured to generate a binary output that is high if either or both of the inputs are high, but to generate a binary output that is low if both inputs are low. Accordingly, OR logic gate 342 in this example will cause transmit information signal 210 to be high when either of the flip-flop outputs 330 or 340 is high, and will cause transmit information signal 210 to be low when both of the flip-flop outputs 330 and 340 are low.

As described above, in addition to being provided to modulation circuit 204, transmit information signal 210 is also coupled to the reset inputs 328 and 338 of the flip-flops. This has the effect of resetting both flip-flops when either produces an output signal. Accordingly, any transition from low to high in transmit information signal 210 will be brief or pulsed, lasting only long enough to reset the flip-flops and cause the OR logic gate inputs to go low, thus causing the transmit information signal to go low as well.

From the above description, it may be seen that transmit information signal 210 may be a bi-level signal having a positive pulse corresponding to each of the transitions in data input signal 208 from '0' to '1' and from '1' to '0.'

In some examples, a delay component 344 is provided at the reset input 328 of positive-edge flip-flop 322 to delay the fed-back transmit information signal 210 by a predetermined amount. In these examples, resets of positive-edge flip-flop 322 will be delayed relative to resets of negative-edge flip-flop 332, causing output 330 to remain high longer than output 340 remains high. Accordingly, delay component 344 has the effect on transmit information signal 210 of causing the duration of each pulse caused by a rising data input signal 208 to be longer than the duration of each pulse caused by a falling data input signal 208. This may facilitate differentiation between the two types of pulses and embed additional information in transmit information signal 210 regarding data input signal 208.

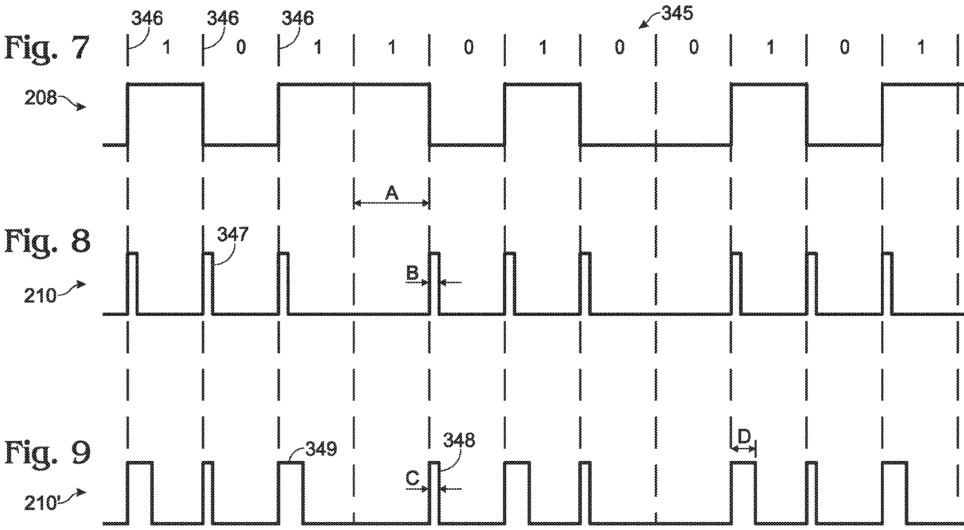

Figs. 7-9 are collectively a timing diagram showing an example of a data input signal 208 and two examples of transmit information signals 210 and 210', based on data input signal 208. Transmit information signal 210 is an example of an equal-pulse signal generated as described above in the discussion of Fig. 6 with no delay 344 at the input to positive edge flip-flop 322. Transmit information signal 210', on the other hand, is an example of an unequal-pulse signal generated with delay 344 implemented.

Fig. 7 shows data input signal 208 with a series of binary logic values 345 shown above corresponding portions of the signal encoding them. Dashed lines 346 indicate clock timing, with each dashed line 346 having a bit period of time of length A corresponding to a single bit. Data input signal 208 has a first binary state for bit period of time A when representative of a data bit '1' and a different binary state for bit period of time A when representative of a data bit '0.' As shown in the drawings, transitions exist between the first binary state and the second binary state.

Fig. 8 shows transmit information signal 210 produced by a non-delayed flip-flop in edge detect circuit 202. As depicted, each positive pulse 347 in signal 210 has a width B, which occurs at each transition in data input signal 208. Pulses 347 do not indicate whether a transition is positive-going or negative-going. Pulse width B is less than bit period of time A and may be approximately one-tenth of the width of bit period of time A.

Fig. 9 shows transmit information signal 210' produced by edge detect circuit 202 with delay component 344. As depicted, positive pulses 348 in signal 210' indicate a change to a value of '0' in signal 208 and have a pulse width C. However, positive pulses 349 indicate a change to a value of '1' and have a pulse width D that is wider than pulse width C. Pulse width D may be longer than pulse width C by the same length of time as the delay used in delay 344 for flip-flop 322.

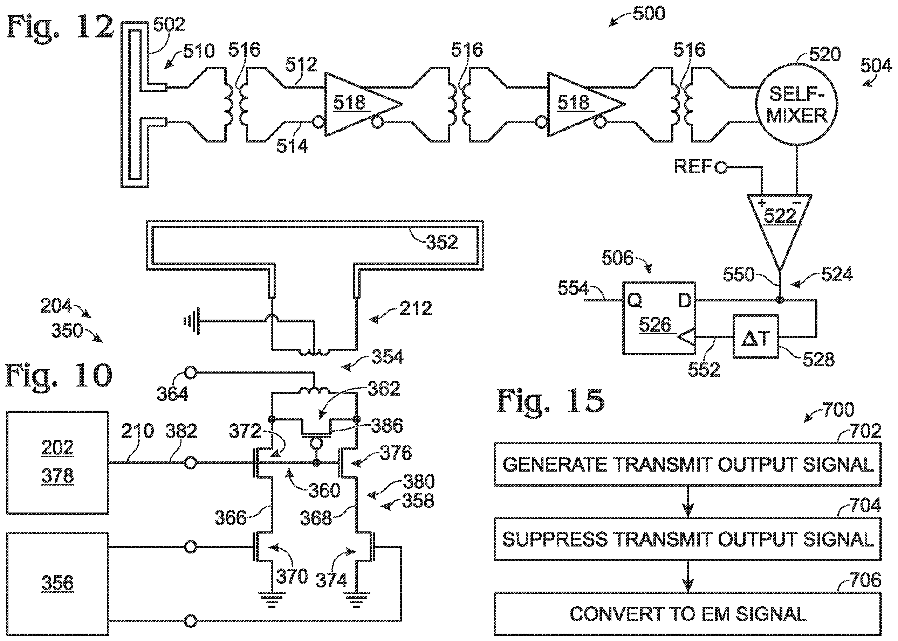

Turning now to Fig. 10, an illustrative example of a modulation circuit 204 is generally indicated at 350, coupled to an antenna 352, which is an example of a transmit transducer 206. Similar to edge detecting circuits 202 and 320, modulation circuit 350 may be located on a die such as die 12 shown in Fig. 1, and may include a transformer 354, a carrier signal generator 356, an amplifier 358, a modulator 360, and a pinch device 362. In this example, transformer 354 may be any suitable transformer coupled to antenna 352 and may receive power on a primary winding from a terminal 364.

A carrier signal may be generated by carrier signal generator 356 and carried by a pair of signal conductors 366 and 368 between carrier signal generator 356 and antenna 352. Signal generator 356 may be any suitable component configured to generate an EHF-frequency carrier signal. For example, signal generator 356 may be a voltage controlled oscillator (VCO).

Amplifier 358 may include any suitable components configured to amplify the carrier signal generated by carrier signal generator 356. In the example depicted in Fig. 10, amplifier 358 is a cascode amplifier including two common-source field-effect transistors (FETs) 370 and 372 connected in series on signal conductor 366 and two common-source FETs 374 and 376 connected in series on signal conductor 368.

In the example depicted in Fig. 10, modulator 360 may receive a modulation signal from an edge detecting circuit 378, which is an example of edge detecting circuit 202. Modulator 360 may include FETs 372 and 376, which may be referred to as modulation FETs. Transmit information signal 210 may be conducted by a signal conductor 382 from edge detecting circuit 378 to the gates of FETs 372 and 376, thereby coupling edge detecting circuit 378 with modulation circuit 350. In this example, transmit information signal 210 modulates the carrier signal by causing FETs 372 and 376 to conduct at a high level when signal 210 is high and to conduct at a lower level or not at all when signal 210 is low. In so doing, FETs 372 and 376 may generate transmit output signal 212 as bursts having the EHF frequency of the carrier signal, with each burst representing a change in the state of the data input signal 208.

With continued reference to the example depicted in Fig. 10, pinch device 362 may be any suitable component configured to suppress or eliminate the transmit output signal 212 when transmit information signal 210 is low. For example, pinch device 362 may include a pinch switch or pinch FET 386 with a source and drain connected respectively to signal conductors 366 and 368.A complement of transmit information signal 210 is applied to the gate of pinch FET 386. Accordingly, pinch FET 386 conducts between source and drain when signal 210 is low, essentially shorting conductors 366 and 368 together. This in turn prevents the carrier signal from reaching transformer 354, thereby eliminating transmit output signal 212 between bursts. Conversely, FET 386 acts essentially as an open circuit when signal 210 is high, allowing operation of the modulation circuit to continue unimpeded.

As described above, signal 212 may be conducted via transformer 354 to antenna 352, where the electrical signal is converted to an EM signal and transmitted.

In other examples, modulation may be carried out as shown in the example of a modulation circuit 204 generally indicated at 390 in Fig. 11. In this example, an edge detect circuit 392 is operatively coupled to modulation circuit 390 through a power switch 394. In this example, when it is in a conducting state, power switch 394 provides power from a power source for a VCO 396 and an amplifier 398, which are analogous to the signal generator and amplification circuit of Fig. 10. Power switch 394 may be any suitable switch configured to conduct or prevent conduction of current based on a signal. For example, power switch 394 may be a FET controlled by a signal applied to the gate. In the example shown in Fig. 11, power switch 394 is controlled by transmit information signal 210 such that the switch conducts power when signal 210 is high. Amplifier 398 generates a bi-level transmit output signal 400 (analogous to signal 212) by turning power on and off to the carrier generator and/or the amplifier. In this example, the output of amplifier 398 is applied to a transformer 402 that feeds signal 400 to an antenna 404. Amplifier 398 may receive power from the power source through transformer 402 and also through power switch 394.

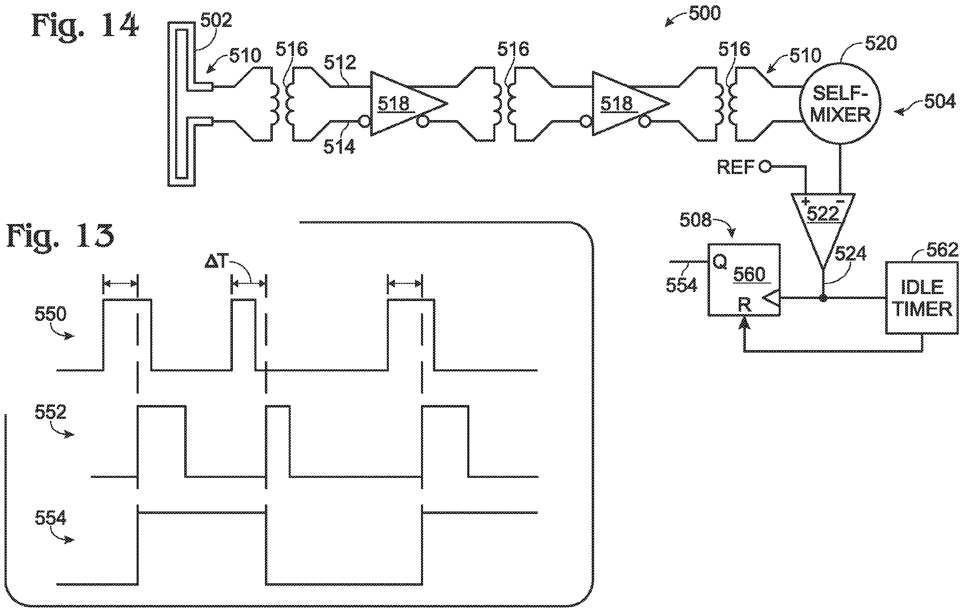

Turning to Figs. 12 and 14, examples of a circuit are generally indicated at 500. Circuits 500 include an antenna 502, which is an example of receive transducer 302, and a demodulation circuit 504, which is an example of demodulation circuit 304. The circuits of Figs. 12 and 14 also include examples of sample circuit 306. Fig. 12 shows a sample circuit 506 and Fig. 14 shows an alternative sample circuit 508.

Antenna 502 may receive a modulated EM signal such as EM signal 214, and convert the EM signal to a receive input signal 510 (analogous to signal 308), which is carried on signal conductors 512 and 514. Signal 510 is passed through demodulation circuit 304, which includes a series of transformers 516 and amplifiers 518 to boost the signal strength, and a self mixer 520. Self mixer 520 responds to the amplified receive input signal 510 by mixing the EHF signal with itself to generate a base signal. In mixing the signal with itself, the carrier frequency is effectively doubled. Because the carrier is already in the EHF range, a doubling raises this frequency to a point where it will be substantially attenuated naturally by natural parasitic features of the circuit, leaving only a base signal.

The base signal is then passed to a comparator 522. Comparator 522 may be any suitable component configured to compare the base signal to a reference level, or threshold, and to generate a receive information signal 524 (analogous to signal 310) having a binary logic value '1' if the threshold is met, and to binary logic value '0' if the threshold is not met.

In sample circuit 506 shown in Fig. 12, receive information signal 524 is passed to the D input of a D-type flip-flop 526. Signal 524 is also passed to the clock input of flip-flop 526, but through a delay device 528 that delays the signal by a predetermined amount greater than the duration of a pulse indicating a value of '0' in the original data input signal but less than the duration of a pulse indicating a value of '1'. This configuration allows the circuit to differentiate between the two types of pulses shown in Fig. 9. As shown in Fig. 13, the D input has an output 550 of the comparator and the clock input has a delayed output 552 of the comparator. A pulse corresponding to a '1' will still be in progress at D when the delayed pulse hits the clock input. However, a shorter pulse corresponding to a '0' will be over by the time the same pulse reaches the clock input. This results in flip-flop 526 generating a data output signal 554 (analogous to signal 312) having the form shown at the bottom of Fig. 13.

In the alternative example of sample circuit 508 depicted in Fig. 14, receive information signal 524 is passed to the input of a toggle-type flip-flop 560. In this case, information signal 524 corresponds to information signal 210 shown in Fig. 8, and no delay is used and the pulses of signal 524 have the same duration. Since the pulses have the same duration, no differentiation is inherently possible between those indicating a '1' and those indicating a '0.' In this example, a pulse corresponding to a positive going transition may be identified by a unique code included in the data stream, which may be provided and detected by conventional means. All following pulses indicate a transition between the two logic states. An idle timer 562 also may be used to reset flip-flop 560 after a certain predetermined idle time, which may be indicated by a certain length of a series of '0' values (i.e., no pulses). Idle timer 562 may be reset by each signal pulse, indicating a value of '1.'

Fig. 15 is a block diagram depicting an exemplary method generally indicated at 700 for modulating EHF signals as is provided by transmitter 152. A first step 702 may include generating by a modulation circuit a transmit output signal having an EHF frequency when a transmit information signal is at a first information state. A second step 704 may include suppressing the transmit output signal when the transmit information signal is at a second information state different than the first information state. A third step 706 may include converting by a transmit transducer the transmit output signal into an electromagnetic signal.

Accordingly, a system or method as described above for delta modulated EHF communication may include one or more of the following examples.

In one example, a system for communicating modulated EHF signals may include a modulation circuit responsive to a bi-level transmit information signal for generating a transmit output signal having an EHF frequency when the transmit information signal is at a first information state and suppressing the transmit output signal when the transmit information signal is at a second information state different than the first information state. A transmit transducer operatively coupled to the modulation circuit may be responsive to the transmit output signal for converting the transmit output signal into an electromagnetic signal.

An edge-detecting circuit may be responsive to a binary data input signal for generating the bi-level transmit information signal. The data input signal may have a first binary state for a bit period of time when representative of a data bit '1' and a second binary state for the bit period of time when representative of a data bit '0,' there being transitions between the first binary state and the second binary state. The edge-detecting circuit may generate the bi-level transmit information signal including an edge-indicating pulse generated in response to each transition in the data input signal between the first and second binary states. The first information state of the transmit information signal may be the state when the edge-indicating pulse is occurring.

The edge-indicating pulse may have a duration less than the bit period of time, and may be less than one-tenth of the bit period of time.

The edge-detecting circuit may include a D-type positive-edge flip-flop having a first D input that is at a continuous logic '1' state, a first clock input for receiving the data input signal, and a first reset input for receiving the bi-level transmit information signal. The positive-edge flip-flop may produce a first flip-flop output signal in response to the states of the signals on the first D input, the first clock input, and the first reset input. The edge-detecting circuit may also include a D-type negative-edge flip-flop having a second D input that is at a continuous logic '1' state, a second clock input receiving the complement of the data input signal, and a second reset input for receiving the bi-level transmit information signal. The negative-edge flip-flop may produce a second flip-flop output signal in response to the states of the signals on the second D input, the second clock input, and the second reset input. The edge-detecting circuit may also include an OR logic gate responsive to the first and second flip-flop output signals for producing the bi-level transmit information signal.

The bi-level information signal may be delayed by a first delay prior to being applied to the first reset input, and may have first edge-indicating pulses corresponding to positive-going transitions in the data input signal. The first edge-indicating pulses each may have a longer duration than each of second edge-indicating pulses corresponding to negative-going transitions.

The system may include a receive transducer responsive to the electromagnetic signal for converting the electromagnetic signal into a receive input signal corresponding to the transmit output signal. The receive input signal may have a first signal strength at intermittent periods and a second signal strength less than the first signal strength otherwise. The system may also include a demodulation circuit operatively coupled to the receive transducer and responsive to the receive input signal for regenerating a receive information signal having a third information state when the receive input signal has the first signal strength and having a fourth information state when the receive input signal has the second signal strength.

The system may also include a sample circuit coupled to the demodulation circuit. The sample circuit may be responsive to the receive information signal for generating a data output signal having a third binary state for a bit period of time when representative of a data bit '1' and a fourth binary state for the bit period of time when representative of a data bit '0.' The sample circuit may generate a transition in the data output signal between the third and fourth binary states each time the receive information signal has the third information state.

The sample circuit may include a D-type receive flip-flop receiving the receive information signal on a D input and a clock input, with the receive information signal on the clock input being delayed by a second delay that includes at least the first delay. The sample circuit may produce the output data signal with a transition from the fourth binary state to the third binary state when the receive information signal has the third information state for a duration longer than the first delay.

The edge-detecting circuit may generate the bi-level information signal with edge-indicating pulses corresponding to positive-going transitions in the data input signal that have durations that are different than durations of edge-indicating pulses corresponding to negative-going transitions.

The system may include a receive transducer responsive to the electromagnetic signal for converting the electromagnetic signal into a receive input signal corresponding to the transmit output signal, the receive input signal having a first signal strength at intermittent periods and a second signal strength less than the first signal strength otherwise. The system may also include a demodulation circuit operatively coupled to the receive transducer and responsive to the receive input signal for regenerating a receive information signal having a third information state when the receive input signal has the first signal strength and having a fourth information state when the receive input signal has the second signal strength.

A sample circuit may be coupled to the demodulation circuit, the sample circuit being responsive to the receive information signal for generating a binary data output signal having a third binary state and a fourth binary state different than the third binary state, the sample circuit generating a transition in the data output signal between the third and fourth binary states each time the receive information signal has the third information state.

The modulation circuit may include a carrier signal generator for generating a carrier signal and a cascode amplifier in communication with the transmit transducer for amplifying the carrier signal received by the cascode amplifier.

The modulation circuit may further include a pair of common-source FETs operating in parallel with one common-source FET receiving a carrier signal that is the negative of a carrier signal that is received by the other common-source FET.

The modulation circuit may further include a pair of signal conductors coupling the carrier signal between the carrier signal generator and the transmit transducer. The cascode amplifier may include a pair of modulation FETs, one modulation FET in series with each conductor of the pair of signal conductors. The pair of modulation FETs may modulate the carrier signal in response to the transmit information signal.

The modulation circuit may include a carrier signal generator coupled to the transmit transducer and a pinch device responsive to the transmit information signal for suppressing the carrier signal when the transmit information signal is in the second information state.

The modulation circuit may include a pair of signal conductors coupling the transmit output signal between the pinch device and the transmit transducer, the pinch device further comprising a pinch switch for shorting the pair of signal conductors when the transmit information signal is in the second information state.

The modulation circuit may include a cascode amplifier in communication with the transmit transducer for amplifying the carrier signal.

The modulation circuit may further include a pair of signal conductors coupling the carrier signal between the carrier signal generator and the transmit transducer. The cascode amplifier may include a pair of modulation FETs, one modulation FET in series with each conductor of the pair of signal conductors, the pair of modulation FETs modulating the carrier signal in response to the transmit information signal.

The modulation circuit may include a carrier signal generator coupled to the transmit transducer for generating a carrier signal, a cascode amplifier for amplifying the carrier signal, and a power switch for coupling a power source to at least one of the carrier signal generator and the cascode amplifier. The power switch may terminate power to the at least one of the carrier signal generator and the cascode amplifier when the transmit information signal is in the second information state.

In another example, a system for communicating modulated EHF signals may include a receive transducer responsive to an electromagnetic signal having the EHF frequency for converting the electromagnetic signal into a receive input signal having a first signal strength for intermittent periods and a second signal strength less than the first signal strength otherwise. A demodulation circuit operatively coupled to the receive transducer may be responsive to the receive input signal for generating a receive information signal having a first information state when the receive input signal has the first signal strength and having a second information state when the receive input signal has the second signal strength.

A sample circuit may be coupled to the demodulation circuit, the sample circuit being responsive to the receive information signal for generating a binary data output signal having a first binary state and a second binary state different than the first binary state. The sample circuit may generate a transition in the data output signal between the first and second binary states each time the receive information signal has the first information state.

The electromagnetic signal may have edge-indicating pulses corresponding to positive-going transitions in a data input signal that have a duration longer than edge-indicating pulses corresponding to negative-going transitions by a first delay. The sample circuit may include a D-type receive flip-flop receiving the receive information signal on a D input and on a clock input. The receive information signal on the clock input may be delayed by a second delay that includes at least the first delay. The flip-flop may produce the output data signal with a transition from the second binary state to the first binary state when the receive information signal has the first information state for a duration longer than the first delay.

In an exemplary method for communicating modulated EHF signals, a modulation circuit may generate a transmit output signal having an EHF frequency when a transmit information signal is at a first information state. The transmit output signal may be suppressed when the transmit information signal is at a second information state different than the first information state. A transmit transducer may convert the transmit output signal into an electromagnetic signal.

A data input signal may have a first binary state for a bit period of time when representative of a data bit '1' and a second binary state for the bit period of time when representative of a data bit '0,' there being transitions between the first binary state and the second binary state. An edge-detecting circuit may generate the transmit information signal including generating an edge-indicating pulse in response to each transition in the data input signal between the first and second binary states, the first information state of the information signal being the state when the edge-indicating pulse is occurring.

Generating an edge-indicating pulse may include generating an edge-indicating pulse having a duration that may be less than the bit period of time, and may be less than one-tenth of the bit period of time.

In the edge detecting circuit, a continuous logic '1' state may be input in a first D input of a D-type positive-edge flip-flop. The data input signal may be input in a first clock input of the positive-edge flip-flop. The bi-level information signal may be input in a first reset input of the positive-edge flip-flop. The positive-edge flip-flop may produce a first flip-flop output signal in response to the states of the signals on the first D input, the first clock input, and the first reset input. A continuous logic '1' state may be input on a second D input of a D-type negative-edge flip-flop. A complement of the data input signal may be input on second clock input of the negative-edge flip-flop. The bi-level information signal may be input on a second reset input of the negative-edge flip-flop. The negative-edge flip-flop may produce a second flip-flop output signal in response to the states of the signals on the second D input, the second clock input, and the second reset input. An OR logic gate may produce the transmit information signal in response to the first and second flip-flop output signals.

The bi-level information signal may be delayed by a first delay time prior to inputting the bi-level information signal in the first reset input. An OR logic gate may produce the bi-level information signal including producing the bi-level information signal with first edge-indicating pulses corresponding to positive-going transitions in the data input signal. Each of the first edge-indicating pulses may have a longer duration than each of second edge-indicating pulses corresponding to negative-going transitions in the data input signal.

A receive transducer may receive the electromagnetic signal and convert the electromagnetic signal into a receive input signal corresponding to the transmit output signal. The receive input signal may have a first signal strength for intermittent periods and a second signal strength less than the first signal strength otherwise. A demodulation circuit may be responsive to the receive input signal, and may regenerate a receive information signal having a third information state when the receive input signal has the first signal strength and having a fourth information state when the receive input signal has the second signal strength.

A sample circuit, in response to the receive information signal, may generate a binary data output signal having a third binary state and a fourth binary state. The binary data output signal may have a transition between the third and fourth binary states each time the receive information signal has the third information state.

The sample circuit may generate an output data signal including inputting on a D input of a D-type receive flip-flop the receive information signal, delaying the receive information signal by a second delay that includes at least the first delay, inputting the delayed receive information signal on a clock input of the receive flip-flop, and producing the output data signal with a transition from the fourth binary state to the third binary state when the receive information signal has the third information state for a duration longer than the first delay.

The bi-level information signal may be generated with first edge-indicating pulses corresponding to positive-going transitions in the data input signal. The first edge-indicating pulses each may have a duration different than a duration of each of second edge-indicating pulses corresponding to negative-going transitions.

A receive transducer may receive the electromagnetic signal and convert the electromagnetic signal into a receive input signal corresponding to the transmit output signal. The receive input signal may have a first signal strength for intermittent periods and a second signal strength otherwise. A demodulation circuit may be responsive to the receive input signal, and may regenerate a receive information signal having a third information state when the receive input signal has the EHF frequency and having a fourth information state when the receive input signal has no frequency.

A sample circuit, in response to the receive information signal, may generate a binary data output signal having a third binary state and a fourth binary state different from the third binary state. The binary data output signal may have a transition between the third and fourth binary states each time the receive information signal has the third information state.

The modulation circuit may receive and amplify a carrier signal, and conduct the amplified carrier signal to the transmit transducer.

generating by the modulation circuit a carrier signal, conducting the carrier signal to the transmit transducer, and suppressing the carrier signal prior to conducting the carrier signal to the transmit transducer when the transmit information signal is in the second information state.

The transmit output signal may be coupled to the transmit transducer at least partially on a pair of signal conductors. The pair of signal conductors may be shorted when the transmit information signal is in the second information state.

The modulation circuit may amplify the carrier signal, and may conduct the amplified carrier signal to the transmit transducer.

Power may be supplied to the modulation circuit, and may be terminated to the modulation circuit in a manner preventing the transmit output signal from being transmitted to the transmit transducer when the transmit information signal is in the second information state.

In another exemplary method for communicating modulated EHF signals, a receive transducer may receive an electromagnetic signal and convert the electromagnetic signal into a receive input signal having a first signal strength for intermittent periods and a second signal strength less than the first signal strength otherwise. A demodulation circuit responsive to the receive input signal may regenerate a receive information signal having a first information state when the receive input signal has the the first signal strength and having a second information state when the receive input signal has the second signal strength.

A sample circuit, in response to the receive information signal, may generate an output data signal having a first binary state and a second binary state. The output data signal may have a transition between the first and second binary states each time the receive information signal has the third information state.

The electromagnetic signal may have first edge-indicating pulses corresponding to positive-going transitions in a data input signal. Each of the first edge-indicating pulses may have a duration longer than each of second edge-indicating pulses corresponding to negative-going transitions by a first delay time. Generating by the sample circuit an output data signal may include inputting on a D input of a D-type receive flip-flop the receive information signal; delaying the receive information signal by a second duration that includes at least the first delay time; inputting the delayed receive information signal on a clock input of the receive flip-flop; and producing the output data signal with a transition from the second binary state to the first binary state when the receive information signal has the first information state for a duration longer than the first delay time.

### Industrial Applicability

The inventions described herein relate to industrial and commercial industries, such as electronics and communications industries using devices that communicate with other devices or devices having communication between components in the devices.

It is believed that the disclosure set forth herein encompasses multiple distinct inventions with independent utility. While each of these inventions has been disclosed in its preferred form, the specific embodiments thereof as disclosed and illustrated herein are not to be considered in a limiting sense as numerous variations are possible. Each example defines an embodiment disclosed in the foregoing disclosure, but any one example does not necessarily encompass all features or combinations that may be eventually claimed. Where the description recites "a" or "a first" element or the equivalent thereof, such description includes one or more such elements, neither requiring nor excluding two or more such elements. Further, ordinal indicators, such as first, second or third, for identified elements are used to distinguish between the elements, and do not indicate a required or limited number of such elements, and do not indicate a particular position or order of such elements unless otherwise specifically stated.

## Claims

1. A system for communicating modulated extremely high frequency, abbreviated as EHF, signals, comprising:
- an edge-detecting circuit (202) responsive to a binary data input signal (208) configured to generate a bi-level transmit information signal (210), the binary data input signal (208) having a first binary state for a bit period of time when representative of a data bit '1' and a second binary state for the bit period of time when representative of a data bit '0,' there being transitions between the first binary state and the second binary state, the bi-level transmit information signal (210) including an edge-indicating pulse having a first duration, the edge indicating pulse generated in response to each transition in the binary data input signal (208) between the first and second binary states;
wherein the edge-detecting circuit (202) includes:
- a D-type positive-edge flip-flop having (322) a first D input (324) that is at a continuous logic '1' state, a first clock input (326) configured to receive the binary data input signal (208), and a first reset input (328) configured to receive the bi-level transmit information signal (210), the positive-edge flip-flop (322) configured to produce a first flip-flop output signal (330) in response to the states of the signals on the first D input (324), the first clock input (326), and the first reset input (328); and
- a D-type negative-edge flip-flop (332) having a second D input (334) that is at a continuous logic '1' state, a second clock input (336) configured to receive the complement of the binary data input signal (208), and a second reset input (338) configured to receive the bi-level transmit information signal (210), the negative-edge flip-flop (332) configured to produce a second flip-flop output signal (340) in response to the states of the signals on the second D input (334), the second clock input (336), and the second reset input (338); and
- an OR logic gate (342) responsive to the first and second flip-flop output signals (330, 340) configured to produce the bi-level transmit information signal (210).
- a modulation circuit (204) responsive to the bi-level transmit information signal (210) configured to generate a transmit output signal (212) operating in the EHF band of electromagnetic frequency spectrum when the bi-level transmit information signal (210) is at a first information state and being suppressed when the bi-level transmit information signal (210) is at a second information state different than the first information state, the transmit output signal (212) being generated by modulating a carrier signal operating in the EHF band with the bi-level transmit information signal (210), the first information state of the bi-level transmit information signal (210) being the state when the edge-indicating pulse occurs; and
- a transmit transducer (206) operatively coupled to the modulation circuit (204) and responsive to the transmit output signal (212) configured to convert the transmit output signal (212) into an electromagnetic signal (214) operating in the EHF band of electromagnetic frequency spectrum.

2. The system of claim 1, wherein the first duration of the edge-indicating pulse is less than the bit period of time.

3. The system of claim 2, wherein the first duration of the edge-indicating pulse is less than one-tenth of the bit period of time.

4. The system of claim 1, wherein the bi-level transmit information signal (210) is delayed by a first delay prior to being applied to the first reset input (328), the bi-level transmit information signal (210) having first edge-indicating pulses corresponding to positive-going transitions in the binary data input signal (208) and second edge-indicating pulses corresponding to negative-going transitions, the first edge-indicating pulses each having the first duration and the second edge-indication pulses each having a second duration, the first duration being a longer duration than the second duration.

5. The system of claim 4, further comprising:
- a receive transducer (302) responsive to the electromagnetic signal (214) configured to convert the electromagnetic signal (214) into a receive input signal (308) corresponding to the transmit output signal (212), the receive input signal (308) having a first signal strength at intermittent periods and a second signal strength less than the first signal strength otherwise; and
- a demodulation circuit (304) operatively coupled to the receive transducer (302) and responsive to the receive input signal (308) configured to regenerate a receive information signal (310) having a third information state when the receive input signal (308) has the first signal strength and having a fourth information state when the receive input signal (308) has the second signal strength.

6. The system of claim 5, further comprising a sample circuit (306) coupled to the demodulation circuit (304), the sample circuit (306) being responsive to the receive information signal (310) configured to generate a binary data output signal (312) having a third binary state for a bit period of time when representative of a data bit '1' and a fourth binary state for the bit period of time when representative of a data bit '0,' the sample circuit (306) configured to generate a transition in the binary data output signal (312) between the third and fourth binary states each time the receive information signal (310) has the third information state.

7. The system of claim 1, wherein the edge-detecting circuit (202) is configured to generate the bi-level transmit information signal (210) with first pulses corresponding to positive-going transitions in the binary data input signal (208) and second pulses corresponding to negative-going transitions in the binary data input signal (208), each first pulse having the first duration and each second pulse having a second duration, the second duration being different than the first duration.

8. The system of claim 1, further comprising:
- a receive transducer (302) responsive to the electromagnetic signal (214) configured to convert the electromagnetic signal (214) into a receive input signal (308) corresponding to the transmit output signal (212), the receive input signal (308) having a first signal strength at intermittent periods and a second signal strength less than the first signal strength otherwise; and
- a demodulation circuit (304) operatively coupled to the receive transducer (302) and responsive to the receive input signal (308) configured to regenerate a receive information signal (310) having a third information state when the receive input signal (308) has the first signal strength and having a fourth information state when the receive input signal (308) has the second signal strength.

9. The system of claim 8, further comprising a sample circuit (306) coupled to the demodulation circuit (304), the sample circuit (306) being responsive to the receive information signal (310) configured to generate a binary data output signal (312) having a third binary state and a fourth binary state different than the third binary state, the sample circuit (306) configured to generate a transition in the binary data output signal (312) between the third and fourth binary states each time the receive information signal (310) has the third information state.

10. A system for communicating modulated extremely high frequency, abbreviated as EHF, signals, comprising:
- a receive transducer (302) responsive to an electromagnetic signal (214) having the EHF frequency configured to convert the electromagnetic signal (214) into a receive input signal (308) having a first signal strength for intermittent periods and a second signal strength less than the first signal strength otherwise, the receive input signal (308) corresponding to a transmit output signal (212) including a carrier signal having the EHF frequency modulated with a bi-level transmit information signal (210), the bi-level transmit information signal (210) including edge-indicating pulses, each edge-indicating pulse generated in response to each transition in a binary data input signal (208) between a first binary state and a second binary state; and
- a demodulation circuit (304) operatively coupled to the receive transducer (302) and responsive to the receive input signal (308) configured to generate a receive information signal (310) having a first information state when the receive input signal (308) has the first signal strength and having a second information state when the receive input signal (308) has the second signal strength; and
- a sample circuit (306) coupled to the demodulation circuit (304), the sample circuit (306) being responsive to the receive information signal (310) configured to generate a binary data output signal (312) having the first binary state and the second binary state different than the first binary state, the sample circuit (306) configured to generate a transition in the binary data output signal (312) between the first and second binary states each time the receive information signal (310) has the first information state;
wherein:
- the electromagnetic signal (214) has edge-indicating pulses corresponding to positive-going transitions in the binary data input signal (208) that have a duration longer than edge-indicating pulses corresponding to negative-going transitions by a first delay; and
- the sample circuit (306) includes a D-type receive flip-flop (526) configured to receive the receive information signal (310) on a D input and on a clock input, the receive information signal (310) on the clock input being delayed by a second delay that includes at least the first delay, and produce the binary output data signal (312) with a transition from the second binary state to the first binary state when the receive information signal (310) has the first information state for a duration longer than the first delay.

11. A method for communicating modulated extremely high frequency, abbreviated as EHF, signals, comprising:
- generating by an edge-detecting circuit (202) a bi-level transmit information signal (210) including an edge-indicating pulse having a first duration in response to each transition in a binary data input signal (202) between a first binary state and a second binary state, wherein the binary data input signal (202) has the first binary state for a bit period of time when representative of a data bit '1' and the second binary state for the bit period of time when representative of a data bit '0,' there being transitions between the first binary state and the second binary state;
wherein generating the bi-level information signal (210) includes:
- producing, by a D-type positive edge flip-flop (322) having a first D input (324) that is at a continuous logic '1' state, a first clock input (326) configured to receive the binary data input signal (208), and a first reset input (328) configured to receive the bi-level transmit information signal (210), a first flip-flop output signal (330) in response to the states of the signals on the first D input (324), the first clock input (326), and the first reset input (328);
- producing, by a D-type negative-edge flip-flop (332) having a second D input (334) that is at a continuous logic '1' state, a second clock input (336) configured to receive the complement of the binary data input signal (208), and a second reset input (338) configured to receive the bi-level transmit information signal (210), a second flip-flop output signal (340) in response to the states of the signals on the second D input (334), the second clock input (336), and the second reset input (338); and
- producing, by an OR logic gate (342) responsive to the first and second flip-flop output signals (330, 340), the bi-level transmit information signal (210);
- generating by a modulation circuit (204) a transmit output signal (212) having an EHF frequency when the bi-level transmit information signal (210) is at a first information state, the first information state of the bi-level transmit information signal (210) being the state when the edge-indicating pulse occurs , the transmit output signal (212) being suppressed when the bi-level transmit information signal (210) is at a second information state different than the first information state, the transmit output signal (212) being generated by modulating a carrier signal having the EHF frequency with the bi-level transmit information signal (210); and
- converting by a transmit transducer (206) the bi-level transmit output signal (212) into an electromagnetic signal (214).

12. A method for communicating modulated extremely high frequency, abbreviated as EHF, signals, comprising:
- receiving by a receive transducer (302) an electromagnetic signal (214);
- converting by the receive transducer (302) the electromagnetic signal (214) into a receive input signal (308) having a first signal strength for intermittent periods and a second signal strength less than the first signal strength otherwise, the receive input signal (308) corresponding to a transmit output signal (212) including a carrier signal having the EHF frequency modulated with a bi-level transmit information signal (210), the bi-level transmit information signal (210) including edge-indicating pulses, each edge-indicating pulse generated in response to each transition in a binary data input signal (208) between a first binary state and a second binary state,
wherein the electromagnetic signal (214) has edge-indicating pulses corresponding to positive-going transitions in the binary data input signal (208) that have a duration longer than edge-indicating pulses corresponding to negative-going transitions by a first delay;
- regenerating by a demodulation circuit (304) responsive to the receive input signal (308), a receive information signal (310) having a first information state when the receive input signal (308) has the first signal strength and having a second information state when the receive input signal (308) has the second signal strength; and
- generating by a sample circuit (306) in response to the receive information signal (310), a binary data output signal (312) having a first binary state and a second binary state, the binary data output signal (312) having a transition between the first and second binary states each time the receive information signal (310) has the first information state,
wherein generating the binary data output signal (312) includes:
- receiving, on a D input and on a clock input of a D-type receive flip-flop (526) of the sample circuit (306), the receive information signal (310), the receive information signal (310) on the clock input being delayed by a second delay that includes at least the first delay; and
- producing, by the D-type receive flip-flop (526), the binary output data signal (312) with a transition from the second binary state to the first binary state when the receive information signal (310) has the first information state for a duration longer than the first delay.

## Patentansprüche

1. System zur Kommunikation modulierter extrem hochfrequenter, im Folgenden auch als EHF bezeichnet, Signale, umfassend:
- eine auf ein binäres Dateneingabesignal (208) reagierende Flankenerkennungsschaltung (202), die konfiguriert ist, ein Zweipegel-Sendeinformationssignal (210) zu erzeugen, wobei das binäre Dateneingabesignal (208) einen ersten binären Zustand für eine Bit-Zeitspanne aufweist, wenn es ein Datenbit '1' repräsentiert, und einen zweiten binären Zustand für die Bit-Zeitspanne aufweist, wenn es ein Datenbit '0' repräsentiert, wobei es Übergänge zwischen dem ersten binären Zustand und dem zweiten binären Zustand gibt, wobei das Zweipegel-Sendeinformationssignal (210) einen Flankenanzeigeimpuls mit einer ersten Dauer beinhaltet, wobei der Flankenanzeigeimpuls als Reaktion auf jeden Übergang im binären Dateneingangssignal (208) zwischen dem ersten und zweiten binären Zustand erzeugt wird;
wobei die Kantenerkennungsschaltung (202) beinhaltet:
- einen D-Typ Positiv-Flanken-Flip-Flop (322) mit einem ersten D-Eingang (324), der sich in einem kontinuierlichen logischen '1'-Zustand befindet, einem ersten Takteingang (326), der konfiguriert ist, das binäre Dateneingangssignal (208) zu empfangen, und einem ersten Reset-Eingang (328), der konfiguriert ist, das Zweipegel-Sendeinformationssignal (210) zu empfangen, wobei der Positiv-Flanken-Flip-Flop (322) konfiguriert ist, im Ansprechen auf die Zustände der Signale des ersten D-Eingangs (324), des ersten Takteingangs (326) und des ersten Reset-Eingangs (328) ein erstes Flip-Flop-Ausgangssignal (330) zu erzeugen;
- einen D-Typ Negativ-Flanken-Flip-Flop (332) mit einem zweiten D-Eingang (334), der sich in einem kontinuierlichen logischen '1'-Zustand befindet, einem zweiten Takteingang (336), der konfiguriert ist, das Komplement des binären Dateneingabesignals (208) zu empfangen, und einem zweiten Reset-Eingang (338), der konfiguriert ist, das Zweipegel-Sendeinformationssignal (210) zu empfangen, wobei der Negativ-Flanken-Flip-Flop (332) konfiguriert ist, im Ansprechen auf die Zustände der Signale des zweiten D-Eingangs (334), des zweiten Takteingangs (336) und des zweiten Reset-Eingangs (338) ein zweites Flip-Flop-Ausgangssignal (340) zu erzeugen; und
- ein auf das erste und zweite Flip-Flop-Ausgangssignal (330, 340) reagierende ODER-Logik-Gatter (342), das konfiguriert ist, das Zweipegel-Sendeinformationssignal (210) zu erzeugen;
- eine auf das Zweipegel-Sendeinformationssignal (210) reagierende Modulationsschaltung (204), die konfiguriert ist, ein Sendeausgangssignal (212) zu erzeugen, welches im EHF-Band des elektromagnetischen Frequenzspektrums arbeitet, wenn sich das Zweipegel-Sendeinformationssignal (210) in einem ersten Informationszustand befindet, und zu unterdrücken, wenn sich das Zweipegel-Sendeinformationssignal (210) in einem zweiten Informationszustand befindet, der sich von dem ersten Informationszustand unterscheidet, wobei das Sendeausgangssignal (212) durch Modulieren eines im EHF-Band arbeitenden Trägersignals mit dem Zweipegel-Sendeinformationssignal (210) erzeugt wird, wobei der erste Informationszustand des Zweipegel-Sendeinformationssignals (210) der Zustand ist, wenn der Flankenanzeigeimpuls auftritt; und
- einen auf das Sendeausgangssignal (212) reagierenden Sendewandler (206), der funktionsfähig mit der Modulationsschaltung (204) gekoppelt ist und konfiguriert ist, das Sendeausgangssignal (212) in ein elektromagnetisches Signal (214) umzuwandeln, das im EHF-Band des elektromagnetischen Frequenzspektrums arbeitet.

2. System nach Anspruch 1, wobei die erste Dauer des Flankenanzeigeimpulses kleiner als die Bit-Zeitspanne ist.

3. System nach Anspruch 2, wobei die erste Dauer des Flankenanzeigeimpulses weniger als ein Zehntel der Bit-Zeitspanne beträgt.

4. System nach Anspruch 1, wobei das Zweipegel-Sendeinformationssignal (210) um eine erste Verzögerung verzögert wird, bevor es an den ersten Reset-Eingang (328) angelegt wird, wobei das Zweipegel-Sendeinformationssignal (210) erste Flankenindikatorimpulse entsprechend positiven Übergängen im binären Dateneingangssignal (208) und zweite Flankenindikatorimpulse entsprechend negativen Übergängen aufweist, wobei die ersten Flankenindikatorimpulse jeweils die erste Dauer und die zweiten Flankenindikatorimpulse jeweils eine zweite Dauer aufweisen, wobei die erste Dauer eine längere Dauer als die zweite Dauer ist.

5. System nach Anspruch 4, weiter umfassend:
- einen auf das elektromagnetische Signal (214) reagierenden Empfangswandler (302), der konfiguriert ist, das elektromagnetische Signal (214) in ein dem Sendeausgangssignal (212) entsprechendes Empfangseingangssignal (308) umzuwandeln, wobei das Empfangseingangssignal (308) eine erste Signalstärke in intermittierenden Perioden und sonst eine zweite Signalstärke aufweist, die geringer als die erste Signalstärke ist; und
- eine auf das Empfangseingangssignal (308) reagierende Demodulationsschaltung (304), die funktionsfähig mit dem Empfangswandler (302) gekoppelt ist und konfiguriert ist, ein Empfangsinformationssignal (310) nachzubilden, welches einen dritten Informationszustand aufweist, wenn das Empfangseingangssignal (308) die erste Signalstärke aufweist, und einen vierten Informationszustand aufweist, wenn das Empfangseingangssignal (308) die zweite Signalstärke aufweist.

6. System nach Anspruch 5, weiter umfassend eine Abtastschaltung (306), die mit der Demodulationsschaltung (304) gekoppelt ist, wobei die auf das Empfangsinformationssignal (310) reagierende Abtastschaltung (306) konfiguriert ist, ein binäres Datenausgangssignal (312) zu erzeugen, welches einen dritten binären Zustand für eine Bit-Zeitspanne aufweist, wenn es ein Datenbit '1' repräsentiert, und einen vierten binären Zustand für die Bit-Zeitspanne aufweist, wenn es ein Datenbit '0' repräsentiert, wobei die Abtastschaltung (306) konfiguriert ist, einen Übergang im binären Datenausgangssignal (312) zwischen dem dritten und dem vierten binären Zustand zu erzeugen, jedes Mal, wenn das Empfangsinformationssignal (310) den dritten Informationszustand aufweist.

7. System nach Anspruch 1, wobei die Flankenerfassungsschaltung (202) konfiguriert ist, das Zweipegel-Sendeinformationssignal (210) mit zu positiven Übergängen im Binärdateneingangssignal (208) korrespondierenden ersten Impulsen und mit zu negativen Übergängen im Binärdateneingangssignal (208) korrespondierenden zweiten Impulsen zu erzeugen, wobei jeder erste Impuls die erste Dauer und jeder zweite Impuls eine zweite Dauer aufweist, wobei die zweite Dauer unterschiedlich von der ersten Dauer ist.

8. System nach Anspruch 1, weiter umfassend:
- einen auf das elektromagnetische Signal (214) reagierenden Empfangswandler (302), der konfiguriert ist, das elektromagnetische Signal (214) in ein dem Sendeausgangssignal (212) entsprechendes Empfangseingangssignal (308) umzuwandeln, wobei das Empfangseingangssignal (308) eine erste Signalstärke in intermittierenden Perioden und sonst eine zweite Signalstärke aufweist, die geringer als die erste Signalstärke ist; und
- eine auf das Empfangseingangssignal (308) reagierende Demodulationsschaltung (304), die funktionsfähig mit dem Empfangswandler (302) gekoppelt ist und konfiguriert ist, ein Empfangsinformationssignal (310) nachzubilden, welches einen dritten Informationszustand aufweist, wenn das Empfangseingangssignal (308) die erste Signalstärke aufweist und einen vierten Informationszustand aufweist, wenn das Empfangseingangssignal (308) die zweite Signalstärke aufweist.

9. System nach Anspruch 8, weiter umfassend eine Abtastschaltung (306), die mit der Demodulationsschaltung (304) gekoppelt ist, wobei die die auf das Empfangsinformationssignal (310) reagierende Abtastschaltung (306) konfiguriert ist, ein binäres Datenausgangssignal (312) zu erzeugen, welches einen dritten binären Zustand und einen vierten binären Zustand, der sich vom dritten binären Zustand unterscheidet, aufweist, wobei die Abtastschaltung (306) konfiguriert ist, einen Übergang im binären Datenausgangssignal (312) zwischen dem dritten und vierten binären Zustand zu erzeugen, jedes Mal, wenn das Empfangsinformationssignal (310) den dritten Informationszustand aufweist.

10. System zur Kommunikation modulierter extrem hochfrequenter, im Folgenden auch als EHF bezeichnet, Signale, umfassend:
- einen auf ein elektromagnetisches Signal (214) mit der EHF-Frequenz reagierenden Empfangswandler (302), der konfiguriert ist, das elektromagnetische Signal (214) in ein Empfangseingangssignal (308) mit einer ersten Signalstärke in intermittierenden Perioden und sonst einer zweiten Signalstärke, die geringer als die erste Signalstärke, umzuwandeln, wobei das Empfangseingangssignal (308) einem Sendeausgangssignal (212) entspricht, das ein Trägersignal, das die EHF-Frequenz hat, moduliert mit einem Zweipegel-Sendeinformationssignal (210) beinhaltet, wobei das Zweipegel-Sendeinformationssignal (210) Flankenanzeigeimpulse beinhaltet, wobei jeder Flankenanzeigeimpuls als Reaktion auf jeden Übergang zwischen einem ersten binären Zustand und einem zweiten binären Zustand in einem binären Dateneingangssignal (208) erzeugt wird;
- eine auf das Empfangseingangssignal (308) reagierende Demodulationsschaltung (304), die funktionsfähig mit dem Empfangswandler (302) gekoppelt ist und konfiguriert ist, ein Empfangsinformationssignal (310) nachzubilden, welches einen ersten Informationszustand aufweist, wenn das Empfangseingangssignal (308) die erste Signalstärke aufweist und einen zweiten Informationszustand aufweist, wenn das Empfangseingangssignal (308) die zweite Signalstärke aufweist; und
- eine Abtastschaltung (306), die mit der Demodulationsschaltung (304) gekoppelt ist, die auf das Empfangsinformationssignal (310) reagierende Abtastschaltung (306) konfiguriert ist, ein binäres Datenausgangssignal (312) zu erzeugen, aufweisend den ersten binären Zustand und den zweiten binären Zustand, der sich vom ersten binären Zustand unterscheidet, wobei die Abtastschaltung (306) konfiguriert ist, einen Übergang im binären Datenausgangssignal (312) zwischen dem ersten und dem zweiten binären Zustand zu erzeugen, jedes Mal, wenn das Empfangsinformationssignal (310) den ersten Informationszustand aufweist;
wobei:
- das elektromagnetische Signal (214) zu positiven Übergängen im Binärdateneingangssignal (208) korrespondierende Flankenanzeigeimpulse aufweist, die eine durch eine erste Verzögerung längere Dauer aufweisen als zu negativen Übergängen im Binärdateneingangssignal (208) korrespondierende Flankenanzeigeimpulse; und
- die Abtastschaltung (306) einen D-Typ Empfangs-Flip-Flop (526) beinhaltet, der konfiguriert ist, das Empfangsinformationssignal (310) an einem D-Eingang und an einem Takteingang zu empfangen, wobei das Empfangsinformationssignal (310) an dem Takteingang um eine mindestens die erste Verzögerung beinhaltende zweite Verzögerung verzögert wird und das binäre Ausgangsdatensignal (312) mit einem Übergang von dem zweiten binären Zustand in den ersten binären Zustand zu erzeugen, wenn das Empfangsinformationssignal (310) den ersten Informationszustand für eine längere Dauer als die erste Verzögerung aufweist.

11. Verfahren zur Kommunikation modulierter extrem hochfrequenter, im Folgenden auch als EHF bezeichnet, Signale, umfassend:
- Erzeugen eines Zweipegel-Sendeinformationssignals (210) mit einem Flankenanzeigeimpuls mit einer ersten Dauer im Ansprechen auf jeden Übergang in einem binären Dateneingangssignal (202) zwischen einem ersten binären Zustand und einem zweiten binären Zustand durch eine Flankenerkennungsschaltung (202), wobei das binäre Dateneingangssignal (202) den ersten binären Zustand für eine Bit-Zeitspanne aufweist, wenn es ein Datenbit '1' repräsentiert, und den zweiten binären Zustand für die Bit-Zeitspanne aufweist, wenn es ein Datenbit '0' repräsentiert, wobei es Übergänge zwischen dem ersten binären Zustand und dem zweiten binären Zustand gibt;
wobei das Erzeugen des Zweipegel-Informationssignals (210) Folgendes beinhaltet:
- Erzeugen, durch einen D-Typ Positiv-Flanken-Flip-Flop (322) mit einem ersten D-Eingang (324), der sich in einem kontinuierlichen logischen '1'-Zustand befindet, einem ersten Takteingang (326), der konfiguriert ist, das binäre Dateneingangssignal (208) zu empfangen, und einem ersten Reset-Eingang (328), der konfiguriert ist, das Zweipegel-Sendeinformationssignal (210) zu empfangen, eines ersten Flip-Flop-Ausgangssignals (330) im Ansprechen auf die Zustände der Signale an dem ersten D-Eingang (324), dem ersten Takteingang (326) und dem ersten Reset-Eingang (328);
- Erzeugen, durch einen D-Typ Negativ-Flanken-Flip-Flop (332) mit einem zweiten D-Eingang (334), der sich in einem kontinuierlichen logischen '1'-Zustand befindet, einem zweiten Takteingang (336), der konfiguriert ist, das Komplement des binären Dateneingabesignals (208) zu empfangen, und einem zweiten Reset-Eingang (338), der konfiguriert ist, das Zweipegel-Sendeinformationssignal (210) zu empfangen, eines zweiten Flip-Flop-Ausgangssignals (340) im Ansprechen auf die Zustände der Signale an dem zweiten D-Eingang (334), dem zweiten Takteingang (336) und dem zweiten Reset-Eingang (338); und
- Erzeugen des Zwei-Pegel-Sendeinformationssignals (210) durch auf das erste und zweite Flip-Flop-Ausgangssignal (330, 340) reagierende ODER-Logik-Gatter (342);
- Erzeugen eines Sendeausgangssignals (212) mit einer EHF-Frequenz durch eine Modulationsschaltung (204), wenn sich das Zweipegel-Sendeinformationssignal (210) in einem ersten Informationszustand befindet, wobei der erste Informationszustand des Zweipegel-Sendeinformationssignals (210) der Zustand ist, in dem der Flankenanzeigeimpuls auftritt, wobei das Sendeausgangssignal (212) unterdrückt wird, wenn sich das Zweipegel-Sendeinformationssignal (210) in einem zweiten Informationszustand befindet, der sich von dem ersten Informationszustand unterscheidet, wobei das Sendeausgangssignal (212) durch Modulieren eines Trägersignals, das die EHF-Frequenz hat, mit dem Zweipegel-Sendeinformationssignal (210) erzeugt wird; und
- Umwandeln des Zweipegel-Sendeausgangssignals (212) durch einen Sendewandler (206) in ein elektromagnetisches Signal (214).

12. Verfahren zur Kommunikation modulierter extrem hochfrequenter, im Folgenden auch EHF genannt, Signale, umfassend:
- Empfangen eines elektromagnetischen Signals (214) durch einen Empfangswandler (302);
- Umwandeln des elektromagnetischen Signals (214) durch den Empfangswandler (302) in ein Empfangseingangssignal (308) mit einer ersten Signalstärke in intermittierenden Perioden und sonst einer zweiten Signalstärke, die geringer ist als die erste Signalstärke, wobei das Empfangseingangssignal (308) einem Sendeausgangssignal (212) entspricht, das ein Trägersignal, das die EHF-Frequenz hat, moduliert mit einem Zweipegel-Sendeinformationssignal (210), beinhaltet, wobei das Zweipegel-Sendeinformationssignal (210) Flankenanzeigeimpulse beinhaltet, wobei jeder Flankenanzeigeimpuls als Reaktion auf jeden Übergang zwischen einem ersten binären Zustand und einem zweiten binären Zustand in einem binären Dateneingangssignal (208) erzeugt wird,
wobei das elektromagnetische Signal (214) positiven Übergängen im binären Dateneingangssignal (208) entsprechende Flankenanzeigeimpulse aufweist, die eine durch eine erste Verzögerung längere Dauer aufweisen als negativen Übergängen entsprechende Flankenanzeigeimpulse;
- Nachbilden eines Empfangsinformationssignals (310), welches einen ersten Informationszustand aufweist, wenn das Empfangseingangssignal (308) die erste Signalstärke aufweist und welches einen zweiten Informationszustand aufweist, wenn das Empfangseingangssignal (308) die zweite Signalstärke aufweist, durch eine Demodulationsschaltung (304) im Ansprechen auf das Empfangseingangssignal (308); und
- Erzeugen eines binären Datenausgangssignals (312) mit einem ersten binären Zustand und einem zweiten binären Zustand, durch eine Abtastschaltung (306) im Ansprechen auf das Empfangsinformationssignal (310), wobei das binäre Datenausgangssignal (312) einen Übergang zwischen dem ersten und dem zweiten binären Zustand aufweist, jedes Mal, wenn das Empfangsinformationssignal (310) den ersten Informationszustand aufweist,
wobei das Erzeugen des binären Datenausgangssignals (312) umfasst:
- Empfangen des Empfangsinformationssignals (310) an einem D-Eingang und an einem Takteingang eines D-Typ Empfangs-Flip-Flops (526) der Abtastschaltung (306), wobei das Empfangsinformationssignal (310) am Takteingang um eine mindestens die erste Verzögerung beinhaltende zweite Verzögerung verzögert wird; und
- Erzeugen des binären Ausgangsdatensignals (312) mit einem Übergang vom zweiten binären Zustand in den ersten binären Zustand durch den D-Typ Empfangs-Flip-Flop (526), wenn das Empfangsinformationssignal (310) den ersten Informationszustand für eine längere Dauer als die erste Verzögerung aufweist.

## Revendications

1. Système de communication de signaux modulés à fréquence extrêmement élevée, abrégée en EHF, comprenant :
- un circuit de détection de front (202) sensible à un signal d'entrée de données binaires (208) configuré pour générer un signal d'information de transmission à deux niveaux (210), le signal d'entrée de données binaires (208) ayant un premier état binaire pendant une période de bit lorsqu'il représente un bit de données '1' et un deuxième état binaire pendant la période de bit lorsqu'il représente un bit de données '0', des passages étant effectués entre le premier état binaire et le deuxième état binaire, le signal d'information de transmission à deux niveaux (210) comportant une impulsion d'indication de front ayant une première durée, l'impulsion d'indication de front étant générée en réponse à chaque passage dans le signal d'entrée de données binaires (208) entre les premier et deuxième états binaires ;
dans lequel le circuit de détection de front (202) comporte :
- une bascule à front positif de type D (322) ayant une première entrée D (324) qui se trouve à un état logique continu '1', une première entrée d'horloge (326) configurée pour recevoir le signal d'entrée de données binaires (208) et une première entrée de réinitialisation (328) configurée pour recevoir le signal d'information de transmission à deux niveaux (210), la bascule à front positif (322) étant configurée pour produire un premier signal de sortie de bascule (330) en réponse aux états des signaux sur la première entrée D (324), la première entrée d'horloge (326) et la première entrée de réinitialisation (328) ; et
- une bascule à front négatif de type D (332) ayant une deuxième entrée D (334) qui se trouve à un état logique continue '1', une deuxième entrée d'horloge (336) configurée pour recevoir le complément du signal d'entrée de données binaires (208), et une deuxième entrée de réinitialisation (338) configurée pour recevoir le signal d'information de transmission à deux niveaux (210), la bascule à front négatif (332) étant configurée pour produire un deuxième signal de sortie de bascule (340) en réponse aux états des signaux sur la deuxième entrée D (334), la deuxième entrée d'horloge (336) et la deuxième entrée de réinitialisation (338) ; et
- une porte logique OU (342) sensible aux premier et deuxième signaux de sortie de bascule (330, 340) configurée pour produire le signal d'information de transmission à deux niveaux (210),
- un circuit de modulation (204) sensible au signal d'information de transmission à deux niveaux (210) configuré pour générer un signal de sortie de transmission (212) fonctionnant dans la bande EHF du spectre de fréquence électromagnétique lorsque le signal d'information de transmission à deux niveaux (210) se trouve à un premier état d'information et étant supprimé lorsque le signal d'information de transmission à deux niveaux (210) se trouve à un deuxième état d'information différent du premier état d'information, le signal de sortie de transmission (212) étant généré en modulant un signal porteur fonctionnant dans la bande EHF avec le signal d'information de transmission à deux niveaux (210), le premier état d'information du signal d'information de transmission à deux niveaux (210) étant l'état où se produit l'impulsion d'indication de front ; et
- un transducteur de transmission (206) couplé de manière fonctionnelle au circuit de modulation (204) et sensible au signal de sortie de transmission (212) configuré pour convertir le signal de sortie de transmission (212) en un signal électromagnétique (214) fonctionnant dans la bande EHF du spectre de fréquence électromagnétique.

2. Système de la revendication 1, dans lequel la première durée de l'impulsion d'indication de front est inférieure à la période de bit.

3. Système de la revendication 2, dans lequel la première durée de l'impulsion d'indication de front est inférieure à un dixième de la période de bit.

4. Système de la revendication 1, dans lequel le signal d'information de transmission à deux niveaux (210) est retardé d'un premier retard avant d'être appliqué à la première entrée de réinitialisation (328), le signal d'information de transmission à deux niveaux (210) ayant des premières impulsions d'indication de front correspondant à des passages positifs dans le signal d'entrée de données binaires (208) et des deuxièmes impulsions d'indication de front correspondant à des passages négatifs, les premières impulsions d'indication de front ayant chacune la première durée et les deuxièmes impulsions d'indication de front ayant chacune une deuxième durée, la première durée étant plus longue que la deuxième durée.

5. Système de la revendication 4, comprenant en outre :
- un transducteur de réception (302) sensible au signal électromagnétique (214) configuré pour convertir le signal électromagnétique (214) en un signal d'entrée de réception (308) correspondant au signal de sortie de transmission (212), le signal d'entrée de réception (308) ayant une première intensité de signal à des périodes intermittentes et, autrement, une deuxième intensité de signal inférieure à la première intensité de signal ; et
- un circuit de démodulation (304) couplé de manière fonctionnelle au transducteur de réception (302) et sensible au signal d'entrée de réception (308) configuré pour régénérer un signal d'information de réception (310) ayant un troisième état d'information lorsque le signal d'entrée de réception (308) a la première intensité de signal et ayant un quatrième état d'information lorsque le signal d'entrée de réception (308) a la deuxième intensité de signal.

6. Système de la revendication 5, comprenant en outre un circuit d'échantillonnage (306) couplé au circuit de démodulation (304), le circuit d'échantillonnage (306) étant sensible au signal d'information de réception (310) configuré pour générer un signal de sortie de données binaires (312) ayant un troisième état binaire pendant une période de bit lorsqu'il représente un bit de données '1' et un quatrième état binaire pendant la période de bit lorsqu'il représente un bit de données '0', le circuit d'échantillonnage (306) étant configuré pour générer un passage dans le signal de sortie de données binaires (312) entre les troisième et quatrième états binaires à chaque fois que le signal d'information de réception (310) a le troisième état d'information.

7. Système de la revendication 1, dans lequel le circuit de détection de front (202) est configuré pour générer le signal d'information de transmission à deux niveaux (210) avec des premières impulsions correspondant à des passages positifs dans le signal d'entrée de données binaires (208) et des deuxièmes impulsions correspondant à des passages négatifs dans le signal d'entrée de données binaires (208), chaque première impulsion ayant la première durée et chaque deuxième impulsion ayant une deuxième durée, la deuxième durée étant différente de la première durée.

8. Système de la revendication 1, comprenant en outre :
- un transducteur de réception (302) sensible au signal électromagnétique (214) configuré pour convertir le signal électromagnétique (214) en un signal d'entrée de réception (308) correspondant au signal de sortie de transmission (212), le signal d'entrée de réception (308) ayant une première intensité de signal à des périodes intermittentes et, autrement, une deuxième intensité de signal inférieure à la première intensité de signal ; et
- un circuit de démodulation (304) couplé de manière fonctionnelle au transducteur de réception (302) et sensible au signal d'entrée de réception (308) configuré pour régénérer un signal d'information de réception (310) ayant un troisième état d'information lorsque le signal d'entrée de réception (308) a la première intensité de signal et ayant un quatrième état d'information lorsque le signal d'entrée de réception (308) a la deuxième intensité de signal.

9. Système de la revendication 8, comprenant en outre un circuit d'échantillonnage (306) couplé au circuit de démodulation (304), le circuit d'échantillonnage (306) étant sensible au signal d'information de réception (310) configuré pour générer un signal de sortie de données binaires (312) ayant un troisième état binaire et un quatrième état binaire différent du troisième état binaire, le circuit d'échantillonnage (306) étant configuré pour générer un passage dans le signal de sortie de données binaires (312) entre les troisième et quatrième états binaires à chaque fois que le signal d'information de réception (310) a le troisième état d'information.

10. Système de communication de signaux modulés à fréquence extrêmement élevée, abrégée en EHF, comprenant :
- un transducteur de réception (302) sensible à un signal électromagnétique (214) ayant la fréquence EHF configuré pour convertir le signal électromagnétique (214) en un signal d'entrée de réception (308) ayant une première intensité de signal pendant des périodes intermittentes et, autrement, une deuxième intensité de signal inférieure à la première intensité de signal, le signal d'entrée de réception (308) correspondant à un signal de sortie de transmission (212) comportant un signal porteur ayant la fréquence EHF modulé avec un signal d'information de transmission à deux niveaux (210), le signal d'information de transmission à deux niveaux (210) comportant des impulsions d'indication de front, chaque impulsion d'indication de front étant générée en réponse à chaque passage dans un signal d'entrée de données binaires (208) entre un premier état binaire et un deuxième état binaire ; et
- un circuit de démodulation (304) couplé de manière fonctionnelle au transducteur de réception (302) et sensible au signal d'entrée de réception (308) configuré pour générer un signal d'information de réception (310) ayant un premier état d'information lorsque le signal d'entrée de réception (308) a la première intensité de signal et ayant un deuxième état d'information lorsque le signal d'entrée de réception (308) a la deuxième intensité de signal ; et
- un circuit d'échantillonnage (306) couplé au circuit de démodulation (304), le circuit d'échantillonnage (306) étant sensible au signal d'information de réception (310) configuré pour générer un signal de sortie de données binaires (312) ayant le premier état binaire et le deuxième état binaire différent du premier état binaire, le circuit d'échantillonnage (306) étant configuré pour générer un passage dans le signal de sortie de données binaires (312) entre les premier et deuxième états binaires à chaque fois que le signal d'information de réception (310) a le premier état d'information ;
dans lequel :
- le signal électromagnétique (214) a des impulsions d'indication de front correspondant à des passages positifs dans le signal d'entrée de données binaires (208) qui ont une durée plus longue que celle des impulsions d'indication de front correspondant à des passages négatifs d'un premier retard ; et
- le circuit d'échantillonnage (306) comporte une bascule de réception de type D (526) configurée pour recevoir le signal d'information de réception (310) sur une entrée D et sur une entrée d'horloge, le signal d'information de réception (310) sur l'entrée d'horloge étant retardé d'un deuxième retard qui inclut au moins le premier retard, et pour produire le signal de sortie de données de binaires (312) avec un passage du deuxième état binaire au premier état binaire lorsque le signal d'information de réception (310) a le premier état d'information pendant une durée plus longue que le premier retard.

11. Procédé de communication de signaux modulés à fréquence extrêmement élevée, abrégée en EHF, comprenant le fait :
- de générer par un circuit de détection de front (202) un signal d'information de transmission à deux niveaux (210) comportant une impulsion d'indication de front ayant une première durée en réponse à chaque passage dans un signal d'entrée de données binaires (202) entre un premier état binaire et un deuxième état binaire, où le signal d'entrée de données binaires (202) a le premier état binaire pendant une période de bit lorsqu'il représente un bit de données '1' et le deuxième état binaire pendant la période de bit lorsqu'il représente un bit de données '0', des passages étant effectués entre le premier état binaire et le deuxième état binaire ;
dans lequel la génération du signal d'information à deux niveaux (210) comporte le fait :
- de produire, par une bascule à front positif de type D (322) ayant une première entrée D (324) qui se trouve à un état logique continu '1', une première entrée d'horloge (326) configurée pour recevoir le signal d'entrée de données binaires (208), et une première entrée de réinitialisation (328) configurée pour recevoir le signal d'information de transmission à deux niveaux (210), un premier signal de sortie de bascule (330) en réponse aux états des signaux sur la première entrée D (324), la première entrée d'horloge (326) et la première entrée de réinitialisation (328) ;
- de produire, par une bascule à front négatif de type D (332) ayant une deuxième entrée D (334) qui se trouve à un état logique continu '1', une deuxième entrée d'horloge (336) configurée pour recevoir le complément du signal d'entrée de données binaires (208), et une deuxième entrée de réinitialisation (338) configurée pour recevoir le signal d'information de transmission à deux niveaux (210), un deuxième signal de sortie de bascule (340) en réponse aux états des signaux sur la deuxième entrée D (334), la deuxième entrée d'horloge (336) et la deuxième entrée de réinitialisation (338) ; et
- de produire, par une porte logique OU (342) en réponse aux premier et deuxième signaux de sortie de bascule (330, 340), le signal d'information de transmission à deux niveaux (210) ;
- de générer par un circuit de modulation (204) un signal de sortie de transmission (212) ayant une fréquence EHF lorsque le signal d'information de transmission à deux niveaux (210) se trouve à un premier état d'information, le premier état d'information du signal d'information de transmission à deux niveaux (210) étant l'état où se produit l'impulsion d'indication de front, le signal de sortie de transmission (212) étant supprimé lorsque le signal d'information de transmission à deux niveaux (210) se trouve à un deuxième état d'information différent du premier état d'information, le signal de sortie de transmission (212) étant généré en modulant un signal porteur ayant la fréquence EHF avec le signal d'information de transmission à deux niveaux (210) ; et
- de convertir par un transducteur de transmission (206) le signal de sortie de transmission à deux niveaux (212) en un signal électromagnétique (214).

12. Procédé de communication de signaux modulés à fréquence extrêmement élevée, abrégée en EHF, comprenant le fait :
- de recevoir par un transducteur de réception (302) un signal électromagnétique (214) ;
- de convertir par le transducteur de réception (302) le signal électromagnétique (214) en un signal d'entrée de réception (308) ayant une première intensité de signal pendant des périodes intermittentes et, autrement, une deuxième intensité de signal inférieure à la première intensité de signal, le signal d'entrée de réception (308) correspondant à un signal de sortie de transmission (212) comportant un signal porteur ayant la fréquence EHF modulé avec un signal d'information de transmission à deux niveaux (210), le signal d'information de transmission à deux niveaux (210) comportant des impulsions d'indication de front, chaque impulsion d'indication de front étant générée en réponse à chaque passage dans un signal d'entrée de données binaires (208) entre un premier état binaire et un deuxième état binaire,
dans lequel le signal électromagnétique (214) a des impulsions d'indication de front correspondant à des passages positifs dans le signal d'entrée de données binaires (208) qui ont une durée plus longue que celle des impulsions d'indication de front correspondant à des passages négatifs d'un premier retard ;
- de régénérer par un circuit de démodulation (304) en réponse au signal d'entrée de réception (308), un signal d'information de réception (310) ayant un premier état d'information lorsque le signal d'entrée de réception (308) a la première intensité de signal et ayant un deuxième état d'information lorsque le signal d'entrée de réception (308) a la deuxième intensité de signal ; et
- de générer par un circuit d'échantillonnage (306) en réponse au signal d'information de réception (310), un signal de sortie de données binaires (312) ayant un premier état binaire et un deuxième état binaire, le signal de sortie de données binaires (312) ayant un passage entre les premier et deuxième états binaires à chaque fois que le signal d'information de réception (310) a le premier état d'information,
dans lequel la génération du signal de sortie de données binaires (312) comporte le fait :
- de recevoir, sur une entrée D et sur une entrée d'horloge d'une bascule de réception de type D (526) du circuit d'échantillonnage (306), le signal d'information de réception (310), le signal d'information de réception (310) sur l'entrée d'horloge étant retardé d'un deuxième retard qui inclut au moins le premier retard ; et
- de produire, par la bascule de réception de type D (526), le signal de sortie de données binaires (312) avec un passage du deuxième état binaire au premier état binaire lorsque le signal d'information de réception (310) a le premier état d'information pendant une durée plus longue que le premier retard.
